# EUROPEAN PATENT APPLICATION

(11) **EP 2 346 090 A2**
(43) Date of publication of application: **20.07.2011**
(21) Application number: 10164627.1
(22) Date of filing: 01.06.2010
(51) Int. Cl.: H01L 31/048

(54) **Solar cell module.**

(30) Priority: 14.01.2010 TW 099100990
(71) Applicant: Motech Industries Inc., Shen-Keng Township, Taipei County 222 Chinese Taipei (TW)
(72) Inventor: Chen, Wen-Pin, County 741, TAINAN (TW)
(74) Representative: Augarde, Eric

(57) **Abstract**

A solar cell module is disclosed. The solar cell module comprises a first protective layer, a solar cell layer, a sealing material layer and a second protective layer, wherein the sealing material layer is composed of polyurethane formed by reacting an acrylic resin with a curing agent such that the yield of the solar cell module can be improved. Depending upon its practical application, the solar cell module may use the sealing material layer in the absence of the Ethylene Vinyl Acetate (EVA)

## Description

### BACKGROUND OF THE INVENTION

### 1. Field of the Invention

The present invention relates to a solar cell module, and more particularly to a solar cell module on which a sealing material (adhesive) layer with tenacity is formed, wherein the sealing material layer is capable of preventing the solar cell layer from crack or damage such that the need of replacing the entire solar cell module can be reduced.

### 2. Description of Related Art

Under the tendency of the world's environmental protection and energetic conservation, all kinds of electricity-generating ways for environmental protection are proposed one after another. The use of the solar cell module for generating electricity is one way of them. The solar cell module is the popular product for people to transform the solar energy into the electrical energy.

The so-called solar cell module is constituted by stacking a solar cell layer, sealing material, a tempering glass for protection, a protective back sheet, a metal frame, an outside conducting wire and so on one with one another. If the solar cell module is further integrated with the application system, then several kinds of solar application systems such as electricity-generating system, charging and power-supplying system, and heating system can be provided.

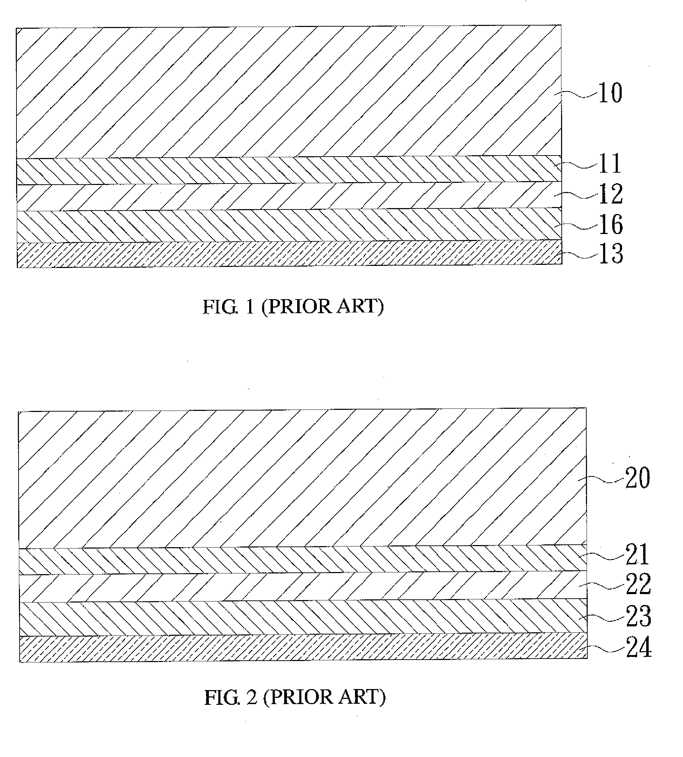

As shown in FIG. 1, which illustrates a cross-sectional view of a conventional solar cell module, the solar cell module comprises a tempering glass 10, a first encapsulation layer 11 (i.e. Ethylene Vinyl Acetate; EVA), a solar cell layer 12, a second encapsulation layer 16 (i.e. ethylene glycol acetic acid), and a back sheet 13, which are stacked in sequence from top to bottom. For the purpose of emphasizing the technical features of this conventional solar cell module, the metal frame and the outside conducting wire are omitted in the FIG. 1.

In the manufacturing process of the above-described solar cell module, the surface of the tempering glass is first covered with the first encapsulation layer. Then, the solar cell layer is provided with matrix arrangement in series or in parallel. Thereafter, the surface of the solar cell layer is covered with the second encapsulation layer followed by mounting the protective back sheet on the surface of the solar cell layer. Finally, through a vacuum compression process and a heating process, these above-mentioned materials are pressed together. As a result, the manufacture of the foregoing solar cell module is completed.

As shown in FIG. 2, which illustrates a cross-sectional view showing another conventional solar cell module, the solar cell module comprises a top tempering glass 20, a poly vinyl butyraldehyde layer 21, a solar cell layer 22, a Poly vinyl sulphide layer 23, and a bottom tempering glass 24, which are stacked in sequence from top to bottom. For the purpose of emphasizing the technical features of the conventional solar cell module, the metal frame and the outside conducting wire are omitted in the FIG. 2.

However, the aforementioned conventional solar cell modules at least have the following problems:
1. The ethylene glycol acetic acid is deteriorated easily and the deterioration of the ethylene vinyl acetate causes the replacement problem of the entire solar cell module:
   The encapsulation material (or agent) is mainly composed of organic polymer material, for example, the above-mentioned ethylene vinyl acetate, which is the most widespread encapsulation material at present. The ethylene vinyl acetate may act as a main encapsulation agent of a crystal solar cell and a thin film solar cell. However, the ethylene vinyl acetate may be deteriorated easily. The deterioration of the ethylene vinyl acetate may cause the replacement of the entire solar cell module, which wastes time and raises the cost of the entire solar cell module.
2. The yield of the solar cell module is reduced due to the easy occurrence of the broken pieces and damages in the manufacture process.

### SUMMARY OF THE INVENTION

To solve the problems of the conventional solar cell modules, a solar cell module capable of solving these conventional problems is disclosed by the present invention.

An object of the present invention is to provide a solar cell module, which comprises a first protective layer, a solar cell layer formed on the first protective layer, a sealing material layer formed on the solar cell layer, and a second protective layer formed on the sealing material layer, wherein the sealing material layer is composed of polyurethane formed by reacting an acrylic resin with a curing agent.

Another object of the present invention is to provide a solar cell module, which comprises a first protective layer, a first encapsulation layer formed on the first protective layer, a solar cell layer formed on the first encapsulation layer, a sealing material layer formed on the solar cell layer, a second encapsulation layer formed on the sealing material layer, and a second protective layer formed on the second encapsulation layer, wherein the sealing material layer is composed of polyurethane formed by reacting an acrylic resin with a curing agent and the first and the second encapsulation layer are composed of ethylene vinyl acetate.

According to the solar cell module of the present invention, the sealing material layer is formed on the solar cell layer, wherein the sealing material layer is composed of polyurethane formed by reacting the acrylic resin with the curing agent. Since the sealing material layer is provided with tenacity and high weatherability, the solar cell layer is protected from being broken or damaged such that the yield of the solar cell module can be improved. In addition, due to the high weatherability of the sealing material layer of the present invention, the need for replacement of the entire solar cell module, which is caused by deterioration of the sealing material layer, can be avoided.

The solar cell module of the present invention comprises the sealing material layer in the absence of the ethylene vinyl acetate such that the replacement of the entire solar cell module caused by the deterioration of the ethylene vinyl acetate can be avoided and the cost of the entire solar cell module can be reduced.

### BRIEF DESCRIPTION OF THE DRAWINGS

FIG. 1 is a schematic cross-sectional view showing a conventional solar cell module.
FIG. 2 is a schematic cross-sectional view showing another conventional solar cell module.
FIG. 3 is a schematic cross-sectional view showing a solar cell module according to a first preferred embodiment of the present invention.
FIG. 4 is a schematic cross-sectional view showing a solar cell module according to a second preferred embodiment of the present invention.

### DETAILED DESCRIPTION OF THE PREFERRED EMBODIMENTS

One or more preferred embodiments of the present invention are explained by reference to one or more figures, wherein identical elements are provided with identical reference numerals.

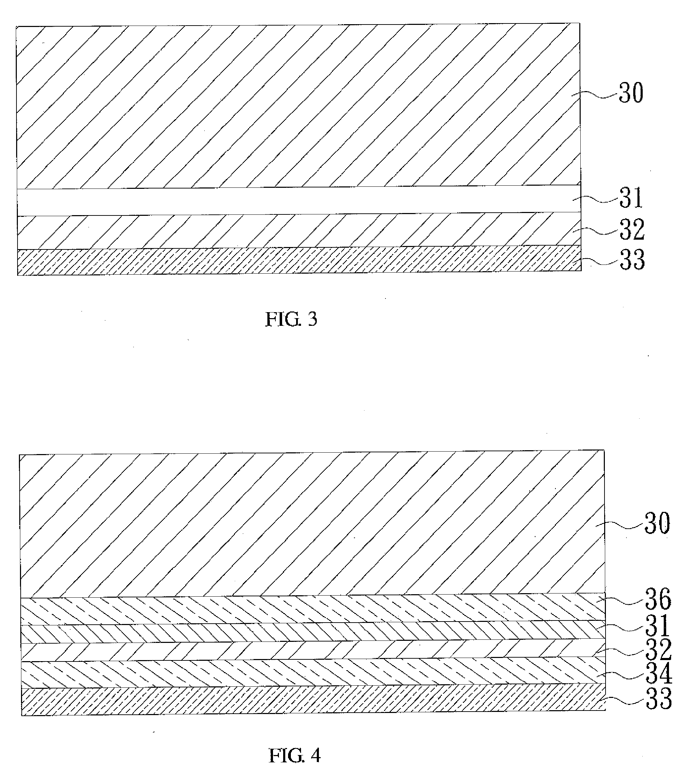

First of all, please refer to the FIG. 3, a cross-sectional view of a solar cell module according to a first preferred embodiment of the present invention is shown. The solar cell module includes a second protective layer 30, wherein the second protector 30 is made of a tempering glass, and the tempering glass may be a soda lime glass or a non-alkali glass. The solar cell module further includes a sealing material layer 31, and the sealing material layer 31 is composed of polyurethane formed by reacting an acrylic resin with a curing agent, wherein the polyurethane is suitable to different linking temperatures and also provided with tenacity and high weatherability.

The solar cell module further includes a solar cell layer 32 and a first protective layer 33, wherein the first protective layer 33 is a back sheet. It is worthy to note that the foregoing second protective layer 30 can also be a back sheet. However, if the second protective layer 30 is the back sheet, then the first protective layer 33 is the tempering glass, wherein this tempering glass may be a soda lime silicate glass or a non-alkali glass. Thereafter, please refer to the FIG. 3, the structure of the solar cell module from bottom to top is sequentially explained as below. The first protective layer 33 is formed on one surface of the solar cell layer 32. In addition, the sealing material layer 31 is formed on another surface of the solar cell layer 32, which is different from the surface of the solar cell layer 32 on which the first protective layer 33 is formed. In addition, the second protective layer 30 is formed on one surface of the sealing material layer 31.

In the manufacture process of the solar cell module of the present invention, the surface of the solar cell layer 32 is uniformly coated with the sealing material layer 31 by using a spread coating method. The solar cell layer 32 is provided with matrix arrangement in series or in parallel. The foregoing spread coating method is such as a spray coating method or a screen printing method, which is performed for about 5 minutes under a temperature of at least 80 degree centigrade. Thereafter, the first protective layer 33 is formed on the surface of the solar cell layer 32, which is different from another surface of the solar cell layer 32 on which the sealing material layer 31 is formed. Besides, the second protective layer 30 is formed on the surface of the sealing material layer 31. Finally, through a vacuum compression process and a heating process, the second protective layer 30, the sealing material layer 31, the solar cell layer 32 and the first protective layer 33 are pressed together. As a result, the manufacture process of the solar cell module is completed.

Please refer to the FIG. 4, a cross-sectional view of the solar cell module according to a second preferred embodiment of the present invention is shown. The solar cell module includes a second protective layer 30, wherein the second protector 30 is a tempering glass and the tempering glass may be a soda lime glass or a non-alkali glass. The solar cell module further includes a sealing material layer 31, and the sealing material layer 31 is composed of polyurethane formed by reacting an acrylic resin with a curing agent, wherein the polyurethane has tenacity and high weatherability and is suitable to different linking temperatures. The solar cell module further includes a solar cell layer 32, a first protective layer 33 and two encapsulation layers 34 and 36 (i.e., ethylene glycol acetic acid), wherein the first protective layer 33 is a back sheet.

Thereafter, please refer to the FIG. 4, the structure of the solar cell module is explained from top to bottom as below. The first protective layer 33 is formed on one surface of the encapsulation layer 34, and the solar cell layer 32 is formed on another surface of the encapsulation layer 34, which is different from the surface of the encapsulation layer 34 on which the first protective layer 33 is formed. In addition, the sealing material layer 31 is formed on one surface of the solar cell layer 32, which is different from another surface of the solar cell layer 32 on which the encapsulation layer 34 is formed. The encapsulation layer 36 is formed on one surface of the sealing material layer 31, which is different from another surface of the sealing material layer 31 on which the solar cell layer 32 is formed. In addition, the second protective layer 30 is formed on one surface of the encapsulation layer 36, which is different from another surface of the encapsulation layer 36 on which the sealing material layer 31 is formed.

In summary, the present invention at least has the following advantages:
1. The need and risk to replace the solar cell module can be reduced:
   In the solar cell module of the present invention, the sealing material layer is formed on the solar cell layer, wherein the sealing material layer is composed of polyurethane formed by reacting the acrylic resin with the curing agent. In addition, due to the high weatherability of the sealing material layer, the problem and risk for replacement of the entire solar cell module, which is caused by deterioration of the sealing material layer, do not occur easily.
2. The solar cell module may have the sealing material layer in the absence of the ethylene vinyl acetate:
   The solar cell module may comprise the sealing material layer without the use of the ethylene vinyl acetate such that the replacement of the entire solar cell module caused by the deterioration of the ethylene vinyl acetate can be avoided and the cost of the entire solar cell module can be reduced.
3. The yield of the solar cell module can be increased:
   According to the solar cell module of the present invention, the sealing material layer is formed on the solar cell layer, wherein the sealing material layer is composed of polyurethane formed by reacting the acrylic resin with the curing agent. Since the sealing material layer is provided with tenacity and high weatherability, the solar cell layer is protected from being broken or damaged such that the yield of the solar cell module can be improved.

Although the present invention has been explained in relation to its preferred embodiment, it is to be understood that many other possible modifications and variations can be made without departing from the spirit and scope of the invention as hereinafter claimed.

## Claims

1. A solar cell module, comprising:
a first protective layer;
a solar cell layer formed on the first protective layer;
a sealing material layer formed on the solar cell layer, wherein the sealing material layer is composed of polyurethane formed by reacting an acrylic resin with a curing agent; and
a second protective layer formed on the sealing material layer.

2. A solar cell module as claimed in claim 1, wherein the second protective layer is a tempering glass, and the first protective layer is a back sheet.

3. A solar cell module as claimed in claim 2, wherein the tempering glass is a soda lime silicate glass or a non-alkali glass.

4. A solar cell module as claimed in claim 1, wherein the second protective layer is a back sheet, and the first protective layer is a tempering glass.

5. A solar cell module as claimed in claim 4, wherein the tempering glass is a soda lime silicate glass or a non-alkali glass.

6. A solar cell module as claimed in claim 1, wherein the sealing material layer is formed on a surface of the solar cell layer by using a spray coating method or a screen printing method, which is performed for at least 5 minutes under a temperature of at least 80 degree centigrade.

7. A solar cell module, comprising:
a first protective layer;
a first encapsulation layer formed on the first protective layer;
a solar cell layer formed on the first encapsulation layer;
a sealing material layer formed on the solar cell layer, wherein the sealing material layer is composed of polyurethane formed by reacting an acrylic resin with a curing agent;
a second encapsulation layer formed on the sealing material layer; and
a second protective layer formed on the second encapsulation layer.

8. A solar cell module as claimed in claim 7, wherein the second protective layer is a tempering glass.

9. A solar cell module as claimed in claim 8, wherein the tempering glass is a soda lime silicate glass or a non-alkali glass.

10. A solar cell module as claimed in claim 7, wherein the first protective layer is a back sheet.

11. A solar cell module as claimed in claim 7, wherein the sealing material layer is formed on a surface of the solar cell layer by using a spray coating method or a screen printing method, which is performed for at least 5 minutes under a temperature of at least 80 degree centigrade.
